# EUROPEAN PATENT SPECIFICATION

(11) **EP 0 283 024 B1**
(45) Date of publication and mention of the grant of the patent: **18.11.1993**
(21) Application number: 88104284.0
(22) Date of filing: 17.03.1988
(51) Int. Cl.: H01L 39/12, H01L 39/24

(54) **Method of manufacturing a ceramic superconductor**
Verfahren zur Herstellung eines keramischen Supraleiters
Méthode de fabrication d'un supra conducteur en céramique

(30) Priority: 20.03.1987 JP 67647/87; 02.04.1987 JP 81817/87
(43) Date of publication of application: 21.09.1988
(73) Proprietor: SUMITOMO ELECTRIC INDUSTRIES LIMITED, Osaka-shi, Osaka 541 (JP)
(72) Inventor: Hitotsuyanagi, Hajime c/o Osaka Works Sumitomo El., Konohana-ku - Osaka (JP); Sawada, Kazuo c/o Osaka Works of Sumitomo El.Ind., Konohana-ku - Osaka (JP); Ohkura, Kengo c/o Osaka Works of Sumitomo El.Ind., Konohana-ku - Osaka (JP); Nakai, Yoshihiro c/o Osaka Works of Sumitomo El., Konohana-ku - Osaka (JP); Hayashi, Kazuhiko c/o Osaka Works of Sumitomo El., Konohana-ku - Osaka (JP)
(74) Representative: KUHNEN, WACKER & PARTNER

(56) References cited:
- EP-A- 0 280 292

## Description

### BACKGROUND OF THE INVENTION

### Field of the Invention

The present invention relates to a method of manufacturing a superconductive conductor, and more particularly, it relates to a method of manufacturing a superconductive conductor which is suitable for manufacturing an elongated superconducting wire for a magnet or a long-distance transmission line.

### Description of the Related Art

In recent years, a superconductive material of ceramics has been watched as that showing a higher critical temperature as described in, for example, Z. Phys. B 1986, vol. 64. p. 189-193 Phys. Rev. Lett. 1987 vol. 58, no.4, p.405-407. A superconductor of such ceramics material is prepared by press-forming ceramics powder of raw materials and thereafter sintering the same. After the press forming, temporary firing may be performed in advance to glost firing, as the case may be.

In the conventional method performed by sintering the powder, it is extremely difficult to elongate the substance since the length thereof is restricted to that of a mold for the press forming. Thus, it has been difficult to apply the conventional superconductor to a device which can make the best use of its superconductivity such as a conductor for forming a coil for a high current density magnet or a long-distance transmission line. In the conventional method, further, complicated steps have been required in order to manufacture an elongated body, leading to inferior productivity.

### SUMMARY OF THE INVENTION

An object of the present invention is to provide a method of efficiently manufacturing a superconductive conductor by a ceramics superconductive material.

The manufacturing method according to the present invention is characterized in that a ceramics material is partially heated/molten to be thereafter coupled with the remaining component under heating in an atmosphere containing said remaining component.

The present invention provides a method of manufacturing a superconductive conductor containing a ceramics superconductive material being in composition generally expressed by a formula AaBbCc, where A represents at least a single sort of element selected from a group of those belonging to the groups Ia, IIa and IIIa of the periodic table, B represents at least a single sort of element selected from a group of those belonging to the groups Ib, IIb and IIIb of the periodic table, C represents at least a single sort of element selected from a group of oxygen, carbon, nitrogen, fluorine and sulfur and a, b and c represent numbers showing composition ratios of A, B and C, and the method comprises the following steps:

First, a material generally expressed by a formula AaBb is molten and an AaBb melt thus obtained by such melting is continuously drawn out from a hole provided in a frame. Then the AaBb melt drawn out from the hole is solidified. Thereafter the solidified body of AaBb is heated in an atmosphere containing C.

As hereinabove described, a superconductive conductor obtained according to the present invention may be, for example, in the composition expressed by AaBbCc, where A contains at least a single sort of element, preferably at least two sorts of elements selected from a group of those belonging to the groups Ia, IIa and IIIa of the periodic table. The elements belonging to the group Ia of the periodic table are H, Li, Na, K, Rb, Cs and Fr. The elements belonging to the group IIa are Be, Mg, Ca, Sr, Ba and Ra. The elements belonging to the group IIIa are Sc, Y, La, Ce, Pr, Nd, Pm, Sm, Eu, Gd, Tb, Dy, Ho, Er, Tm, Yb, Lu, Ac, Th, Pa, U, Np, Pu, Am, Cm, Bk, Cf, Es, Fm, Md, No and Lr.

The elements belonging to the group Ib of the periodic table are Cu, Ag and Au and the elements belonging to the group IIb are Zn, Cd and Hg, while the elements belonging to the group IIIb are B, Al, Ga, In and Tl.

Examples of the atmosphere containing C are that containing oxygen or nitrogen, a carbon monoxide atmosphere, a carbon dioxide atmosphere and a hydrogen sulfide atmosphere.

According to the present invention, the material AaBb substantially enters an alloy state when being cooled/solidified, to have flexibility. Therefore, the material AaBb thus cooled/solidified is superior in workability to ceramics. Thus, a superconductive conductor can be easily obtained in an arbitrary final configuration by providing the material AaBb with such a configuration to be obtained in the stage after cooling/solidification.

The raw material AaBb employed in the present invention hardly reacts with a part or an apparatus such as a crucible, with which the same is brought into contact in manufacturing, as compared with AaBbCc in general, whereby the melting/solidification method can be easily industrially carried out.

Further, AaBb is generally superior in thermal conductivity to AaBbCc, whereby it is possible to increase the speed for drawing out the same, which is in a molten state.

In a preferred embodiment according to the present invention, a material generally expressed by a formula AaBb is molten to be drawn out through a hole provided in a frame of a high temperature exceeding a melting point of AaBb. The frame of such a high temperature is so employed that a conductor being circular in section, a deformed conductor or a strip-shaped conductor can be easily obtained by devising the configuration of the frame, i.e., the sectional configuration of a portion for passing a melt of AaBb.

The AaBb melt thus drawn out may be solidified by forcible cooling or natural standing.

The AaBb solidified body may be heated in an atmosphere containing C through the heat in melting of AaBb itself. Thus, it is not necessary to re-heat the same by specific heating means. In this case, the atmosphere containing C is preferably provided in continuation to the high-temperature frame, so that C can be more efficiently coupled to AaBb.

The AaBb solidified body may be temporarily cooled to be not more than a prescribed temperature and then re-heated, to be coupled with C under the atmosphere containing C in this state.

The AaBb solidified body is preferably solidified to provide a unidirectional solidified member or a monocrystal member, whereby there is a possibility that a superconductive conductor having excellent superconductivity may be obtained.

Further, preferably at least copper is contained as B and at least oxygen is contained as C in the aforementioned composition formula, in order to increase the critical temperature.

According to this embodiment, an elongated body of an arbitrary sectional configuration can be drawn out with relatively small force by employing the high-temperature frame as hereinabove described.

When the AaBb solidified body is provided as a unidirectional solidified member or a monocrystal body, more effective use of superconductivity may be made in the form of an elongated superconductive conductor. Such a unidirectional solidified member or monocrystal body can be easily obtained since the AaBb melt is drawn out through the high-temperature frame.

According to this embodiment, further, the melt is drawn out through the frame of a high temperature, whereby an elongated body which is varied in sectional configuration can be easily obtained to provide a superconductive conductor in the form of a fine wire or a tape-like superconductive conductor by devising the sectional configuration of the high-temperature frame. Thus, an elongated superconductive conductor can be efficiently produced with no complicated mold or apparatus and through no troublesome steps.

Thus, it is possible to industrially produce an elongated superconductive conductor being most applicable to form a long-distance transmission line or a coil for a high current density magnet, which can make the most effective use of superconductivity.

It is pointed out here that the inventive manufacturing method is also applicable to manufacturing of a superconductive conductor being in the form other than an elongated body.

In another preferred embodiment of the present invention, the material AaBb is molten and drawn out through a hole provided in a frame and then immediately brought into conatact with a cooling medium to be cooled/solidified. Thereafter the substance is heated in an atmosphere containing C.

In the aforementioned step, the cooling medium is preferably prepared by a liquid such as water. Further, the substance obtained through the said cooling/solidifying step is preferably provided in an amorphous state, so that deeper infiltration of C is facilitated in a later heating step or superior flexibility is provided in this state, as the case may be. The outer diameter or thickness of the substance after cooling/solidification is preferably selected to be not more than 100 µm, in order to facilitate infiltration of C as deep as possible in the later heating step, as well as to further stabilize a superconductive state of a superconductive conductor, which may be obtained through performance of no specific working thereafter.

According to this embodiment, the material AaBb is molten and then drawn out into the cooling medium through the hole to be cooled/solidified in a prescribed configuration. AaBb is easily cooled and solidified since the same is generally superior in thermal conductivity to AaBbCc. Thus, AaBb can be easily and uniformly quenched/solidified, to be readily provided in amorphous structure after cooling/solidification.

Further, AaBb hardly reacts with ceramics forming a crucible or a nozzle as compared with AaBbCc in general, and hence the same can be easily industrially handled in a molten state. Thus, industrialization is facilitated with importance in industry.

In addition, AaBb can be drawn out into the cooling medium through the hole in the molten state and cooled/solidified, to be extremely easily elongated. Thus, the elongated substance is thereafter heated in the atmosphere containing C, so that a superconductive conductor containing a ceramics superconductive material can be easily obtained. Namely, an elongated wire, particularly a fine wire, or a thin tape-like substance can be easily obtained to further widen the range of application of such a superconductive conductor.

These and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a sectional view schematically showing an apparatus employed for carrying out first Example of the present invention; and
Fig. 2 is a sectional view schematically showing an apparatus employed for carrying out second Example of the present invention.

### DESCRIPTION OF THE PREFERRED EMBODIMENTS

### Example 1

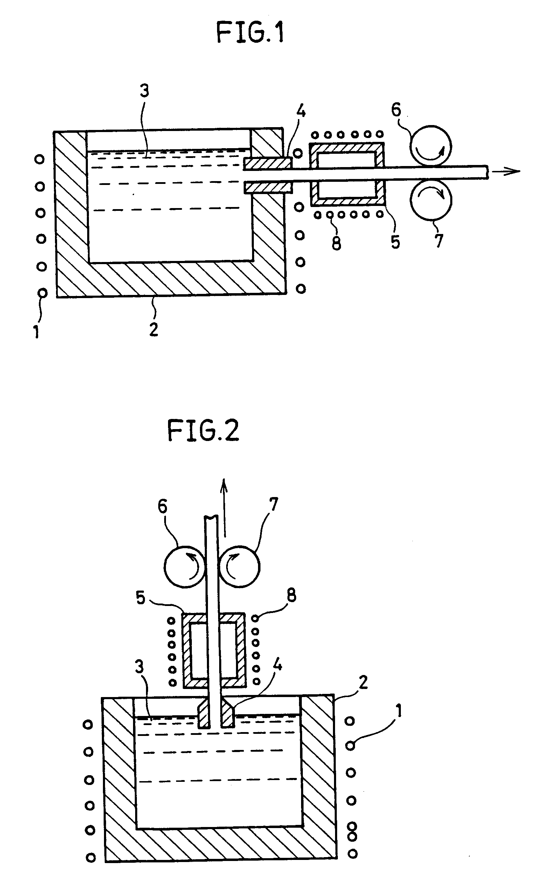

An elongated superconductive conductor was obtained through an apparatus as shown in Fig. 1. Referring to Fig. 1, this apparatus has a crucible 2 provided on its exterior with a heater 1, a high temperature frame 4 provided in a side wall portion of the crucible 2, an oxygen atmosphere furnace 5 outwardly adjacent to the high temperature frame 4 and rolls 6 and 7 for drawing out a solidified body. The atmosphere furnace 5 is also provided with a heater 8 on its periphery.

YBa₂Cu₃ was heated/molten in the crucible 2 to obtain a melt 3, which was then drawn out from the high temperature frame 4 of 1.0 mm in inner diameter and immediately passed through the oxygen atmosphere furnace 5 under oxygen partial pressure of 2.00 x 10⁴ Pa (150 mmHg) at a temperature of 800°C, thereby to obtain a ceramics elongated body of YBa₂Cu₃O₇₋ₓ. This ceramics elongated body presented superconductivity at 90 K.

### Example 2

An elongated ceramics superconductive conductor was prepared through an apparatus as shown in Fig. 2. Referring to Fig. 2, numeral 1 indicates a heater and numeral 2 indicates a crucible, while numeral 3 indicates a melt and numeral 4 indicates a high temperature frame provided on the melt 3. An oxygen atmosphere furnace 5 is provided above the high temperature frame 4, and a pair of rolls 6 and 7 are provided above the atmosphere furnace 5, to be rotated in directions shown by arrows in the figure for drawing out a solidified ceramics body. The atmosphere furnace 5 is also provided with a heater 8 on its periphery.

A material being in composition of (La_{0.925}Sr_{0.075})₂Cu was heated/molten in the crucible 1 to be drawn out from the high temperature frame 4 having a passage portion of 0.5 mm in thickness and 10 mm in width to be immediately passed through the oxygen atmosphere furnace 5 under oxygen partial pressure of 2.00 x 10⁴ Pa (150 mmHg) at a temperature of 780°C, thereby to obtain a ceramics body having layer perovskite structure of (La_{0.925}Sr_{0.075})₂CuO₂. This ceramics body presented superconductivity at 40 K.

### Example 3

Y_{0.4}Ba_{0.6}Cu containing 0.7 atomic percent of Be as an impurity was heated/molten in a crucible and drawn out into flowing water through a nozzle of 100 µm in pore diameter by Ar gas pressure, to be solidified in the form of a fine wire. This substance was heated in a furnace under oxygen partial pressure of 2.67 x 10⁴ Pa (200 Torr). at 1100°C for two hours, to obtain a superconductive conductor containing a ceramics superconductive material of Be_{0.007}Y_{0.4}Ba_{0.6}CuO₃. This superconductive conductor presented superconductivity at 90 K.

### Example 4

La_{1.66}Sr_{0.34}Cu was heated/molten in a crucible to prepare a tape-like body of 30 µm in thickness and 60 mm in width by the so-called roll quench method. This substance was heated in a furnace of 1000° under oxygen partial pressure off 2.67 x 10⁴ Pa (200 Torr). for two hours, to obtain a superconductive conductor containing a ceramics superconductive material having layer perovskite structure of La_{1.66}Sr_{0.34}CuO₄. This superconductive conductor presented superconductivity at 30 K.

### Example 5

Bi₂Sr₂Ca₂Cu₃ was heated/molten in a crucible to prepare a tape-like body of 100 µm in thickness and 5 mm in width by the so-called roll quench method. This substance was heated in a furnace of 830°C under oxygen pressure of 1.01 x 10⁵ Pa (1 atm). for two hours, to obtain a superconductive conductor containing a ceramics superconductive material having layer structure of Bi₂Sr₂Ca₂Cu₃O_{X}. This superconductive conductor presented superconductivity at 105 K.

Although the present invention has been described and illustrated in detail, it is clearly understood that the same is by way of illustration and example only and is not to be taken by way of limitation, the spirit and scope of the present invention being limited only by the terms of the appended claims.

## Claims

1. A method of manufacturing a superconductive conductor formed by a ceramics superconductive material being in composition generally expressed by a formula AaBbCc, where A represents at least a single sort of element selected from a group consisting of: H, Li, Na, K, Rb, Cs, Fr; Be, Mg, Ca, Sr, Ba, Ra; Sc, Y, La, Ce, Pr, Nd, Pm, Sm, Eu, Gd, Tb, Dy, Ho, Er, Tm, Yb, Lu, Ac, Th, Pa, U, Np, Pu, Am, Cm, Bk, Cf, Es, Fm, Md, No, Lr; and Bi;
B represents at least a single sort of element selected from a group consisting of: Cu, Ag, Au; Zn, Cd, Hg; B, Al, Ga, In, Tl;
C represents at least a single sort of element selected from a group consisting of: oxygen, carbon, nitrogen, fluorine and sulfur; and
a, b and c represent numbers showing composition ratios of A, B and C respectively, said method comprising:
a step of melting a material generally expressed by a formula AaBb, where A, B, a and b represent those described above;
a step of continuously drawing out a melt of said AaBb through a hole provided in a frame;
a step of solidifying said AaBb melt drawn out from said hole; and
a step of heating a solidified body of said AaBb in an atmosphere containing said C.

2. A method of manufacturing a superconductive conductor in accordance with claim 1, wherein
said drawing out step comprises a step of heating said frame to a high temperature exceeding a melting point of said AaBb.

3. A method of manufacturing a superconductive conductor in accordance with claim 1 or 2, wherein
said A contains at least two sorts of elements selected from said group as defined in claim 1.

4. A method of manufacturing a superconductive conductor in accordance with claim 3, wherein
at least copper is contained as said B and at least oxygen is contained as said C.

5. A method of manufacturing a superconductive conductor in accordance with claim 2, wherein
said AaBb solidified body is either a unidirectionally elongated solidified member or a monocrystal body.

6. A method of manufacturing a superconductive conductor in accordance with claim 2, wherein
said AaBb solidified body is brought into a prescribed temperature through heat in melting of said AaBb, to be coupled with said C in said atmosphere containing said C.

7. A method of manufacturing a superconductive conductor in accordance with claim 6, wherein
said atmosphere containing said C is provided in continuation to said frame of a high temperature.

8. A method of manufacturing a superconductive conductor in accordance with claim 2, wherein
said AaBb solidified body is re-heated to be coupled with said C under said atmosphere containing said C in this state.

9. A method of manufacturing a superconductive conductor in accordance with claim 1, wherein
said solidifying step comprises a step of bringing said AaBb melt obtained by said drawing out step into contact with a cooling medium.

10. A method of manufacturing a superconductive conductor in accordance with claim 9, wherein
at least copper is contained as said B and at least oxygen is contained as said C.

11. A method of manufacturing a superconductive conductor in accordance with claim 9, wherein
said cooling medium is a liquid.

12. A method of manufacturing a superconductive conductor in accordance with claim 9, wherein
said AaBb solidified body is in amorphous structure after cooling/solidification.

13. A method of manufacturing a superconductive conductor in accordance with claim 9, wherein
the outer diameter or thickness of said cooled/solidified substance is not more than 100 µm.

14. A superconductive conductor obtainable by a method according to claim 1.

15. A superconductive conductor in accordance with claim 14, wherein
said A contains at least two sorts of elements selected from said group as defined in claim 1.

16. A superconductive conductor in accordance with claim 15, wherein
at least copper is contained as said B and at least oxygen is contained as said C.

17. A superconductive conductor in accordance with claim 16, wherein
at least yttrium and barium are contained as said A.

## Patentansprüche

1. Ein Verfahren zum Herstellen eines Supraleiters, der durch ein keramisches supraleitendes Material gebildet ist, das in der Zusammensetzung im allgemeinen durch eine Formel AaBbCc ausgedrückt wird, wobei
A wenigstens eine einzelne Elementart repräsentiert, die aus einer Gruppe ausgewählt ist, bestehend aus: H, Li, Na, K, Rb, Cs, Fr; Be, Mg, Ca, Sr, Ba, Ra; Sc, Y, La, Ce, Pr, Nd, Pm, Sm, Eu, Gd, Tb, Dy, Ho, Er, Tm, Yb, Lu, Ac, Th, Pa, U, Np, Pu, Am, Cm, Bk, Cf, Es, Fm, Md, No, Lr; und Bi;
B wenigstens eine einzelne Elementart repräsentiert, die aus einer Gruppe ausgewählt ist, bestehend aus: Cu, Ag, Au; Zn, Cd, Hg; B, Al, Ga, In, Tl;
C wenigstens eine einzelne Elementart repräsentiert, die aus einer Gruppe ausgewählt ist, bestehend aus: Sauerstoff, Kohlenstoff, Stickstoff, Fluor und Schwefel; und
a, b und c Zahlen repräsentieren, die die Zusammensetzungsverhältnisse von A, B und C zeigen,
wobei das Verfahren beinhaltet:
einen Schritt des Schmelzens eines Materiales, das im allgemeinen durch eine Formel AaBb ausgedrückt wird, wobei A, B, a und b jene oben beschriebenen repräsentieren;
einen Schritt des kontinuierlichen Herausziehens einer Schmelze aus AaBb durch ein Loch, das in einem Gestell vorgesehen ist;
einen Schritt des Festwerdens der AaBb-Schmelze, die aus dem Loch herausgezogen wurde; und
einen Schritt des Erwärmens eines festgewordenen Körpers aus AaBb in einer Atmosphäre, die C enthält.

2. Ein Verfahren zum Herstellen eines Supraleiters nach Anspruch 1, wobei
der Schritt des Herausziehens einen Schritt des Erwärmens des Gestells auf eine hohe Temperatur beinhaltet, die einen Schmelzpunkt des AaBb übersteigt.

3. Ein Verfahren zum Herstellen eines Supraleiters nach Anspruch 1 oder 2, wobei
A wenigstens zwei Elementarten enthält, die aus der in Anspruch 1 definierten Gruppe ausgewählt sind.

4. Ein Verfahren zum Herstellen eines Supraleiters nach Anspruch 3, wobei
wenigstens Kupfer als B enthalten ist und wenigstens Sauerstoff als C enthalten ist.

5. Ein Verfahren zum Herstellen eines Supraleiters nach Anspruch 2, wobei
der festgewordene AaBb-Körper entweder ein unidirektionales, längliches, festgewordenes Teil oder ein monokristalliner Körper ist.

6. Ein Verfahren zum Herstellen eines Supraleiters nach Anspruch 2, wobei
der festgewordene AaBb-Körper auf eine vorgeschriebene Temperatur durch die Wärme beim Schmelzen des AaBb gebracht wird, um mit C in der C-haltigen Atmosphäre verbunden zu werden.

7. Bin Verfahren zum Herstellen eines Supraleiters nach Anspruch 6, wobei
die C-haltige Atmosphäre in Fortsetzung zu dem Gestell mit einer hohen Temperatur vorgesehen ist.

8. Ein Verfahren zum Herstellen eines Supraleiters nach Anspruch 2, wobei
der festgewordene AaBb-Körper wiedererwärmt wird, um mit C in der Atmosphäre verbunden zu werden, die C in diesem Stadium enthält.

9. Ein Verfahren zum Herstellen eines Supraleiters nach Anspruch 1, wobei
der Schritt des Festwerdens einen Schritt des Inkontaktbringens der AaBb-Schmelze, die durch den Schritt des Herausziehens erhalten wurde, mit einem Kühlmedium beinhaltet.

10. Ein Verfahren zum Herstellen eines Supraleiters nach Anspruch 9, wobei
wenigstens Kupfer als B enthalten ist und wenigstens Sauerstoff als C enthalten ist.

11. Ein Verfahren zum Herstellen eines Supraleiters nach Anspruch 9, wobei
das Kühlmedium eine Flüssigkeit ist.

12. Ein Verfahren zum Herstellen eines Supraleiters nach Anspruch 9, wobei
der festgewordene AaBb-Körper nach dem Kühlen/Festwerden amorphe Struktur hat.

13. Ein Verfahren zum Herstellen eines Supraleiters nach Anspruch 9, wobei
der äußere Durchmesser oder die Dicke der gekühlten/festgewordenen Substanz nicht mehr als 100 µm beträgt.

14. Ein Supraleiter, der durch ein Verfahren nach Anspruch 1 erhältlich ist.

15. Ein Supraleiter nach Anspruch 14, wobei
A wenigstens zwei Elementarten enthält, die aus der in Anspruch 1 definierten Gruppe ausgewählt sind.

16. Ein Supraleiter nach Anspruch 15, wobei
wenigstens Kupfer als B enthalten ist und wenigstens Sauerstoff als C enthalten ist.

17. Ein Supraleiter nach Anspruch 16, wobei
wenigstens Yttrium und Barium als A enthalten sind.

## Revendications

1. Procédé de fabrication d'un supraconducteur en céramique, composé d'un matériau céramique supraconducteur, dont la composition est exprimée par la formule générale AaBbCc, dans laquelle
A représente au moins une sorte unique d'élément choisi dans le groupe composé de : H, Li Na, K, Rb, Cs, Fr; Be, Mg, Ca, Sr, Ba, Ra; Sc, Y, La, Ce, Pr, Nd, Pm, Sm, Eu, Gd, Tb, Dy, Ho, Er, Tm, Yb, Lu, Ac, Th, Pa, U, Np, Pu, Am, Cm, Bk, Cf, Es, Fm, Md, No, Lr; et Bi;
B représente au moins une sorte unique d'élément choisi dans le groupe composé de : Cu, Ag, Au; Zn, Cd, Hg; B, Al, Ga, In, Tl;
C représente au moins une sorte unique d'élément choisi dans le groupe composé de : oxygène, carbone, azote, fluorure et sulfure; et
a, b et c représentent des nombres donnant les rapports de composition respectifs de A, B et C, ledit procédé comprenant les étapes de :
fusion d'un matériau représenté par la formule générale AaBb, dans lequel A, B, a et b représentent des matériaux décrits ci-dessus;
extrusion en continu du produit en fusion composé dudit AaBb, à travers un trou ménagé dans un cadre;
solidification dudit AaBb fondu extrait dudit trou; et
chauffage d'un corps solidifié composé dudit AaBb, dans une atmosphère contenant ledit C.

2. Procédé de fabrication d'un supraconducteur selon la revendication 1, dans lequel
ladite étape d'extrusion comprend une étape de chauffage dudit cadre à une température dépassant le point de fusion dudit AaBb.

3. Procédé de fabrication d'un supraconducteur selon la revendication 1 ou 2, dans lequel
ledit A comprend au moins deux sortes d'éléments choisis dans ledit groupe défini à la revendication 1.

4. Procédé de fabrication d'un supraconducteur selon la revendication 3,
dans lequel 8 contient au moins du cuivre et C contient au moins de l'oxygène.

5. Procédé de fabrication d'un supraconducteur selon la revendication 2, dans lequel
ledit corps en AaBb solidifié est soit un organe solidifié allongé unidirectionnel, soit un corps monocristallin.

6. Procédé de fabrication d'un supraconducteur selon la revendication 2, dans lequel
ledit corps en AaBb solidifié est placé à une température prescrite au moyen de la chaleur dégagée lors de la fusion dudit AaBb pour être couplé avec ledit C, dans ladite atmosphère contenant ledit C.

7. Procédé de fabrication d'un supraconducteur selon la revendication 6, dans lequel
ladite atmosphère contenant ledit C est fournie de façon continue audit cadre placé à température élevé.

8. Procédé de fabrication d'un supraconducteur selon la revendication 2, dans lequel
ledit corps en AaBb solidifié est soumis à un nouveau chauffage, pour être couplé audit C, sous ladite atmosphère contenant C à cet état.

9. Procédé de fabrication d'un supraconducteur selon la revendisation 1, dans lequel
ladite étape de solidification comprend une étape de mise en contact avec un milieu de refroidissement dudit AaBb fondu obtenu par ladite étape d'extrusion.

10. Procédé de fabrication d'un supraconducteur selon la revendication 9, dans lequel
B contient au moins du cuivre et C contient au moins de l'oxygène.

11. Procédé de fabrication d'un supraconducteur selon la revendication 9, dans lequel
ledit milieu de refroidissement est un liquide.

12. Procédé de fabrication d'un supraconducteur selon la revendisation 9, dans lequel
ledit corps en AaBb solidifié présente une structure amorphe après le refroidissement/la solidification.

13. Procédé de fabrication d'un supraconducteur selon la revendication 9, dans lequel
le diamètre extérieur ou l'épaisseur de ladite substance refroidie/solidifiée n'excède pas 100 µm.

14. Supraconducteur pouvant être obtenu au moyen d'un procédé selon la revendication 1.

15. Supraconducteur sel on la revendication 14, dans lequel ledit A contient au moins deux sortes d'éléments choisis dans ledit groupe, tel que défini à la revendication 1.

16. Supraconducteur selon la revendication 15 dans lequel B contient au moins du cuivre et C contient au moins de l'oxygêne.

17. Supraconducteur sel on la revendication 16 dans lequel A contient au moins de l'yttrium et du barium.
